# EUROPEAN PATENT APPLICATION

(11) **EP 2 424 111 A1**
(43) Date of publication of application: **29.02.2012**
(21) Application number: 10013987.2
(22) Date of filing: 26.10.2010
(51) Int. Cl.: H03K 17/082

(54) **Current limiter auto off transistor**

(30) Priority: 24.08.2010 IT PZ20100003
(71) Applicant: ASPEK SRL, 85100 Potenza (PZ) (IT)
(72) Inventor: Bilancia, Giuseppe, 85100 Potenza (IT)

(57) **Abstract**

A current supplier that switches off automatically when the current provided overcomes a settled limit.
This device is composed of three semiconductor base elements; they are connected together and can be easily integrated on silicon to form a new family of electronic components, identifiable with their own schematic symbol.
The advantage achieved is the rapid and total current supply interruption in case of overcurrent or short circuit. This interruption ensures the current supplier total integrity.

## Description

### DESCRIPTION

Application field: Any electrical or electronic system that requires the current supplier device protection and/or the applied load protection.

Prior art: Current limiter and protection electronic circuits based on semiconductor elements. Technical problem: In typical current limiter electronic circuits an short circuit on output terminals causes a simple "limitation" of the current. This means that the output power must be dissipated by the current supply device with the result of its easy breakage. Many applications require the full protection of both the load and the current supply device. Such protection is not always guaranteed by the simple "limitation" of current.

Solution of technical problem: Total protection of both the load and the Current supply circuit is simply obtained by making the fast "interruption" of power supply.

Description of one or more forms of implementation: Currently the "interruption" of the current is achieved with passive circuits such as fuses or with complexes active semiconductor circuits.

Fuses problem behavior due to their slow action; the actual active semiconductor circuits are complex, expensive and not always effective.

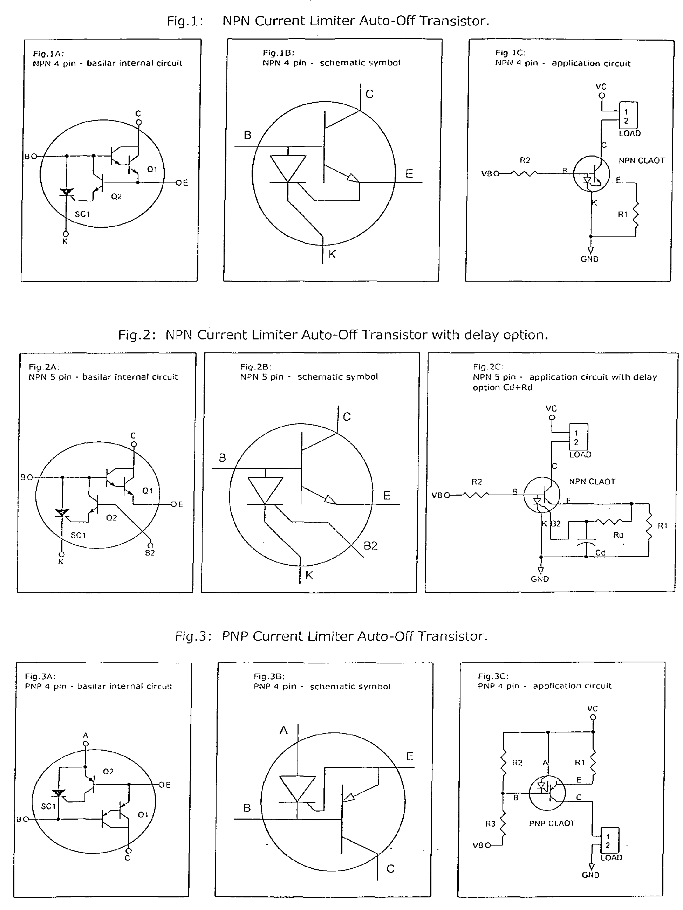

Description of drawings: The main figure that represents this invention is the Fig.1 entitled "Current Limiter Auto-Off NPN Transistor".

This figure consists of three designs:
Fig.1A is the basic circuit that gives rise to the component CLAOT.
Fig.1B is the schematic symbol that represents the CLAOT.
Fig.1C is the application circuit whose components must be sized according to the desired functionality of the application.

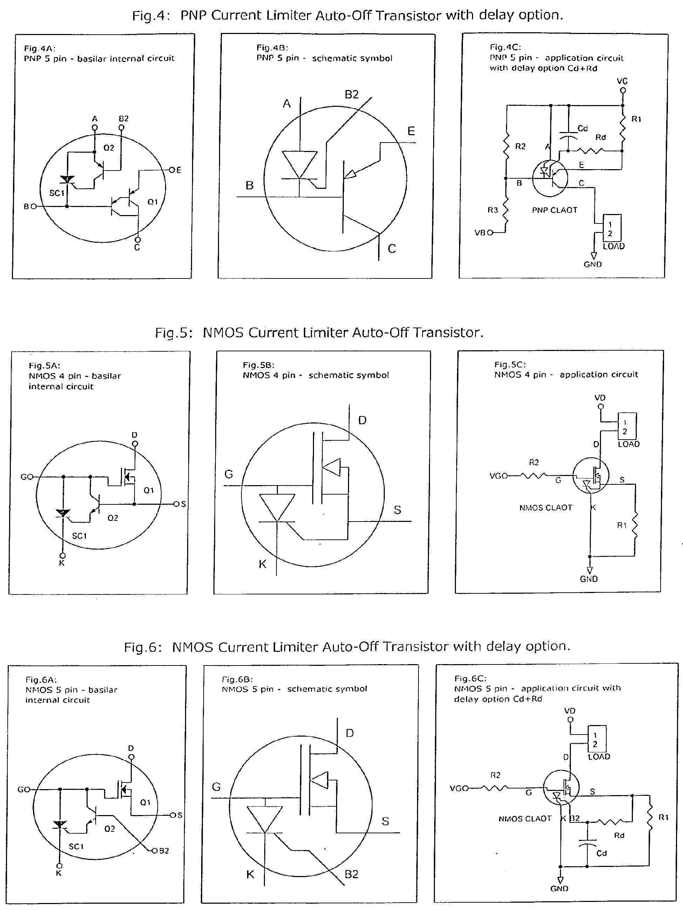

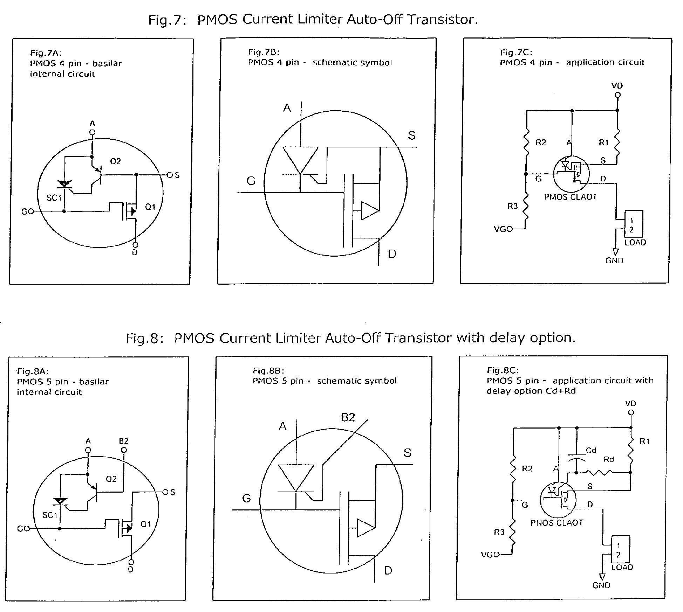

The remaining figures: Fig.2, Fig.3, Fig.4, Fit.5, Fig.6, Fig.7, Fig.8, are related to the practicable functional variants of the invention.

Functioning: The base electric circuit of this invention is shown in [Fig. 1A]. The circuit is composed of three semiconductor base elements; we'll call these elements with the acronym CLAOT. The CLAOT current supply is the transistor [Fig.1A-Q1]; it is in the ON state when on its base is applied a positive voltage. The CLAOT components that implement the electronic protection are the transistor [Fig.1 A-Q2] and the SCR [Fig.1 A-SC 1].

All these three base electronic components connected as shown in [Fig. 1A] produce a new electronic component; its schematic symbol is shown in [Fig.1B] and has the following pins: C, E, B, K.

The functionality of CLAOT is demonstrates by the application circuit visible in [Fig.iC]. .. Applying main voltage [Fig.1C-VC] and the drive voltage [Fig. 1C-VB] the CLAOT is in the ON condition and a current through the load [Fig.1 C-LOAD] and the transistor [Fig. 1A-Q1] and the resistor [Fig. 1C-R1]. Until the voltage drop on the resistor [Fig.1C-R1] is below 0.7 volts the transistor [Fig.1A-Q2] is iii the OFF condition and thus the SCR [Fig.1A-SC1] is in OFF condition, in this situation the load is normally supplied. Indicating with !max the maximum current that you want to deliver on the load, the value of resistor [Fig. 1C-R1] is obtained whit the following formula: R1 = 0.7 / lmax.

When, for any faifure, the load current exceeds Imax, the voltage drop across the resistor [Fig.1C-R1] exceeds the 0.7 volts needed to send the transistor [Fig.1A-Q2] in conduction. This generates a trigger that sets in the fixed active state the SCR [Fig.1A-SC1], which in turn lowers the potential of the base of the transistor [Fig.1A-Q1] implementing the shutdown. This is the condition of protection of the CLAOT which turns off automatically by i-eiiioviiic, all power to the load. The CLAOT remain in the condition of protection until will be present the drive voltage [Fig.1C-VB]. To restore the initial condition of normal operation is necessary to remove and replace the drive voltage [Fig.1C-VB] so as to turn off the SCR [Fig.lA-SC1].

Industrial application: Industrial implementation of this invention can be realized with existing standard components and used in any applications requiring overcurrent and/or short circuit protection obtained with the fast interruption of supply current. The same circuit can be integrated on silicon to form a new family of electronic components, in this way would be a more cost effective than that achieved with separate components. Finally the CLAOT can be always directly integrated on silicon in support of already exist complex integrated circuits to protect all terminals from overload and short circuit.

Advantages: The main advantage of this invention is to obtain a feature of total protection against overcurrent and short circuit using a simple circuit that uses only three standard semiconductor components.

The tripping of the protection on this circuit is very fast. The circuit is simple, intuitive and is easily achievable with already exist standard components. The circuit is also easily integrable on silicon to form a new family of electronic components.

The circuit lends itself to easy implementation of different variants and also the possible inclusion of protection diodes on the main junctions.

The circuit lends itself to the possible integration with other existing electronic devices integrated circuit (such as microprocessors, microcontrollers, DSPs, programmable logic, power drivers, etc...) to implement the overcurrent and short circuit protection of the all terminals, in the order to make these devices almost indestructible.

Variations: A circuital variant of the CLAOT is visible on [Fig.2]. Creating a five pins component you can insert a delay network for delay the intervention of the electronic protection, for example see the application circuit of [Fig.2C]. The presence of the resistor [Fig.2C-Rd] and the capacitor [Fig.2C-Cd] is useful to retard the ignition of the transistor [Fig.2A-Q2]. This variant is useful for the applications that do not like the immediate action of protection.

The other circuital variants are obtained through the replacement of NPN components with PNP, NMOS and PMOS components. The functionality of these variants is simple and intuitive similar to that of the primary version.

The presence of variants can make a truly "complete" new family of semiconductor components, useful to meet the diverse needs of electronic protection against overcurrent and short circuit.

## Claims

1. A new NPN current supplier elcctronic device achieved with only three basic semiconductor components, interconnected as in [Fig.1 A], easily achievable with standard components already existing and/or integrated on silicon as a single component Sy171bOIICaIIy shown in [Fig. I B], which automatically turns off when a short circuit or overcurrent condition when used in the application circuit visible in [Fig.1C].

2. A new NPN current supplier electronic device, according to previous claim, whose the wiring diagram is shown in [Fig.2A], whose schematic symbol is shown in [Fig.2B], complete with delay network shown in [Fig 2C].

3. A new electronic device according to claim 1 but realized with PNP components whose schematic is shown in [Fig.3A], whose schematic symbol is shown in [Fig.3B], whose application circuit is shown in [Fig.3C].

4. A new PNP current supplier electronic device, according to previous claim, whose the wiring diagram is shown in [Fig.4A], whose schematic symbol is shown in [Fig.4B], complete with delay network shown in [Fig 4CJ.

5. A new electronic device according to claim 1 but realized with NMOS components whose schematic is shown in [Fig.5A], whose schematic symbol is shown in [Fig.58], whose application circuit is shown in [Fig .5C].

6. A new NMOS current supplier electronic device, according to previous claim, whose the wiring diagram is shown in [Fig.6A], whose schematic symbol is shown in [Ftg.6B], compete with delay network shown in [Fig.6C].

7. A new electronic device according to claim 1 but realized with PMOS components whose schematic is shown in [Fig.7A], whose schematic symbol is shown in [Fig.7B], whose application circuit is shown in [Fig .7C].

8. A new PMOS current supplier electronic device, according to previous claim, whose the wiring diagram is shown in [Fig.8A], whose schematic symbol is shown in [Fig.8B], complete with delay network shown in [Fig 8C].

9. Anew electronic device according to claims 1, 2, 3, 4, 5, 6, 7 and 8 by adding protection diodes on the various junctions.

10. The applicability of the new operating principle obtained by CLAOT, according to claims l, 2, 3, 4, 5, 6, 7, 8 and 9, for silicon integrated protection to the output terminals of already exist integrated circuits.
